# EUROPÄISCHE PATENTSCHRIFT

(11) **EP 1 783 779 B1**
(45) Veröffentlichungstag und Bekanntmachung des Hinweises auf die Patenterteilung: **02.07.2008**
(21) Anmeldenummer: 06022111.6
(22) Anmeldetag: 21.10.2006
(51) Int. Cl.: G11C 29/46, G11C 29/48, G11C 29/24, G11C 29/44

(54) **Integrierte Schaltung mit integrierter Testhilfe-Teilschaltung**
Integrated circuit with integrated test aid sub-circuit
Commutation intégrée dotée d'une commutation partielle de programme d'aide à la mise au point

(30) Priorität: 27.10.2005 DE 102005052269
(43) Veröffentlichungstag der Anmeldung: 09.05.2007
(73) Patentinhaber: ATMEL Germany GmbH, 74072 Heilbronn (DE)
(72) Erfinder: Hauser, Clemens, 74074 Heilbronn (DE)
(74) Vertreter: Müller, Wolf-Christian

(56) Entgegenhaltungen:
- DE-A1- 10 064 478
- US-A- 5 132 937
- US-A- 5 600 271
- US-A1- 2003 160 620
- US-B1- 6 356 105
- US-B1- 6 624 656

## Beschreibung

Die Erfindung betrifft eine Integrierte Schaltung, mit wenigstens einem digitalen Eingang, der eine erste Teilschaltung und eine zweite Teilschaltung aufweist, die erste Teilschaltung weist eine erste Stromquelle auf, die ein Potenzial an dem Eingang bei fehlendem Eingangssignal auf einem definierten Wert hält, die zweite Teilschaltung ist für die Bereitstellung eines schaltungsinternen Signals ausgebildet, dessen Zustand sich nicht unmittelbar an einem Ausgang der Schaltung zeigt, wobei die erste Teilschaltung einen Steuereingang für ein Steuersignal und eine zweite, in Abhängigkeit eines am Steuereingang anlegbaren Steuersignals schaltbare Stromquelle aufweist, die eine Strom-Spannungs-Charakteristik am digitalen Eingang ändert, wenn das Steuersignal am Steuereingang anliegt.

Unter einem digitalen Eingang wird dabei ein Eingang mit einem Schwellenwertschalter verstanden, der ein Eingangssignal erst dann an eine interne Signalverarbeitung weiterleitet, wenn das Eingangssignal einen vorgegebenen Schwellenwert überschreitet. Wenn dem Eingang kein Eingangssignal zugeführt wird, können elektromagnetische Einflüsse aus der Umgebung grundsätzlich Potenzialschwankungen an dem Eingang erzeugen, die den Schwellenwert überschreiten. Dies ist unerwünscht. Zur Vermeidung der unerwünschten Zustände dient die genannte Teilschaltung. Die Teilschaltung weist zum Beispiel eine Stromsenke auf, die in der Lage ist, einen Strom vorbestimmter Maximalstärke von dem Eingang zu ziehen. Der Schwellenwert kann erst dann überschritten wenn, wenn ein in den Eingang hineinfliessender Signalstrom grösser als der Strom der Stromsenke ist. Ein solche auch als Pull Down Stromquelle bezeichnete Stromsenke hält das Potenzial am Eingang auf einem Wert unterhalb des Schwellenwertes fest. Analog hält eine Pull Up Stromquelle das Potenzial oberhalb des Schwellenwerts fest.

Im Betrieb Integrierter Schaltung treten Änderungen von Zuständen schaltungsinterner Signale auf, die sich nicht unmittelbar im Verhalten der Eingangssignale und Ausgangssignale der Integrierten Schaltung abbilden. Für eine Funktionsprüfung der Schaltung am Ende eines Fertigungsprozesses kann die Frage, ob und gegebenenfalls zu welchem Zeitpunkt eine solche Zustandsänderung auftritt, wichtig sein. Grundsätzlich kann für das interne Signal ein eigener Anschluss vorgesehen werden, an dem das interne Signal zu Testzwecken abgegriffen werden kann. Bei einer vorgegebenen Schaltung ist die Zahl möglicher Anschlüsse jedoch bereits aus Platzgründen beschränkt. Ausserdem stellt jeder Anschluss einen unerwünschten Eingang für Störeinflüsse wie ESD-Impulse dar.

Eine weitere Möglichkeit zur Überprüfung eines internen Signals besteht in der Analyse des Eingangs-Ausgangssignal-Verhaltens der Integrierten Schaltung. Dabei ist jedoch problematisch, dass sich das interne Signal unter Umständen nur sehr indirekt und mit grosser zeitlicher Verzögerung in einem regulären Ausgangssignal abbildet, so dass interne Signale nur unvollständig oder mit einem hohen Messzeitaufwand erfasst werden können, was insbesondere bei einer Bandende-Prüfung zu einer Produktionsraten-Verringerung führen kann.

Eine Schaltung und ein Verfahren der eingangs genannten Art ist jeweils aus der DE 100 64 478 A1 bekannt. Diese Schrift betrifft das Problem, dass Messpadflächen innerhalb der Schaltung und zusätzliche Pins, die zum externen Messen von Signalen benötigt werden, gerade bei hochintegrierten Schaltkreisen einen erheblichen Anteil an der Gesamtfläche des Schaltkreises einnehmen. Aufgrund des grossen Anteils an der gesamten Chipfläche ist der dadurch verursachte Anteil an den Gesamtkosten einer Schaltung erheblich, was sich negativ auf die Wirtschaftlichkeit auswirkt. Zur Abhilfe wird dort vorgeschlagen, die innerhalb einer integrierten Schaltung von einer Schaltungseinheit erzeugten Signale, die im normalen Betriebsmodus nicht an den Ausgängen messbar sind, für Funktionskontrollen als Prüfsignale auf die vorhandenen Signalausgänge zu schalten. Hierzu wird bei anliegender Versorgungsspannung an wenigstens einem Signalausgang der integrierten Schaltung ein bestimmter Potenzialwert angelegt und damit die integrierte Schaltung in einen Testmodus umgeschaltet.

Wenn ein internes Prüfsignal auf einen Ausgang geschaltet wird, kann das reguläre Ausgangssignal nicht gleichzeitig abgenommen werden. Prüfungen, bei denen das interne Signal und das reguläre Ausgangssignal erforderlich sind, können daher nur nacheinander ausgeführt werden, was die Messzeit erhöht.

Aus der US 6,624,656 B1 ist ein integrierter Schaltkreis mit einen Signalanschluss bekannt, dem jeweils ein Pull-Down-Widerstand und ein Pull-Up-Widerstand zugeordnet sind. Zudem ist jeweils zwischen das Versorgungspotential und den zugehörigen Widerstand ein Steuertransistor eingeschleift, der von dem integrierten Schaltkreis angesteuert werden kann und somit eine alternative Bereitstellung des einen Versorgungspotentials oder des anderen Versorgungspotentials an den Signalanschluss ermöglicht. Dabei ist der integrierte Schaltkreis derart eingerichtet, dass der Signalpegel am Signalanschluss wahlweise auf eine logische 1, auf eine logische 0 oder auf das am Signalanschluss anliegende Eingangssignal gezogen werden kann.

Vor diesem Hintergrund besteht die Aufgabe der Erfindung in der Angabe einer Integrierten Schaltung, die eine Überprüfung von Zuständen interner Signale ohne zusätzliche Anschlüsse und mit einem verringerten Messzeitaufwand erlaubt.

Diese Aufgabe wird bei einer Integrierten Schaltung der eingangs genannten Art dadurch gelöst, dass die erste Stromquelle und die zweite Stromquelle jeweils als Pull-Down-Stromquelle oder als Pull-Up-Stromquelle oder als Pull-Down-Widerstand oder als Pull-Up-Widerstand ausgebildet sind.

Die Teilschaltung ist mit einem ohnehin vorhandenen Eingang gekoppelt. Ihre Strom-Spannungs-Charakteristik ist daher prinzipiell über den Eingang erfassbar. Durch die Änderung der Strom-Spannungs-Charakteristik als Funktion des internen Signals wird die Änderung des Zustandes des internen Signals in ein Signalverhalten an dem Eingang abgebildet und kann ohne zusätzlichen Anschluss ausgelesen werden.

Dabei ist vorgesehen, dass der digitale Eingang eine erste Pull Down Stromquelle oder Pull-Up-Stromquelle aufweist, die einen ersten Strom von einem Eingang eines Schwellenwertschalters zieht oder liefert, und dass die Teilschaltung eine schaltbare Pull Down Stromquelle oder Pull-Up-Stromquelle aufweist, die vom schaltungsinternen Signal geschaltet wird und einen zweiten Strom von dem Eingang des Schwellenwertschalters zieht oder an diesen liefert.

Alternativ ist vorgesehen, dass der digitale Eingang einen ersten Pull Down Widerstand (Pull Up Widerstand) aufweist, der zwischen einem Eingang eines Schwellenwertschalters und einem ersten (zweiten) Bezugspotenzial liegt und dass die Teilschaltung einen schaltbaren Pull Down Widerstand (Pull Up Widerstand) aufweist, der vom schaltungsinternen Signal geschaltet wird und zwischen dem Eingang des Schwellenwertschalters und dem ersten (zweiten) Bezugspotenzial liegt.

Mit Blick auf Ausgestaltungen der Schaltung ist bevorzugt, dass das schaltungsinterne Signal das Steuersignal ist. Diese Ausgestaltung ist schaltungstechnisch besonders einfach zu realisieren. Entsprechend ist die korrespondierende Verfahrensausgestaltung einfach durchzuführen.

Bevorzugt ist auch, dass das Steuersignal das Ergebnis einer UND-Verknüpfung eines Freigabesignals mit dem schaltungsinternen Signal ist. Durch ein solches Freigabesignal kann festgelegt werden, wann die Änderung der Strom-Spannungs-Charakteristik erlaubt ist. Dies ist hilfreich, wenn die Änderung den Normalbetrieb beeinflussen könnte.

Diese Ausgestaltungen belegen die breite Verwendbarkeit der Erfindung. Weitere Vorteile ergeben sich aus der Beschreibung und den beigefügten Figuren.

Es versteht sich, dass die vorstehend genannten und die nachstehend noch zu läuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: eine Integrierte Schaltung mit einer ersten Ausgestaltung der Erfindung;
- Fig. 2: zeitliche Verläufe von Signalen, wie sie in der Ausgestaltung der Fig. 1 bei einer Durchführung des Verfahrens auftreten;
- Fig. 3: eine Ausgestaltung der Schaltung, die mit einem Freigabesignal arbeitet; und
- Fig. 4: eine Ausgestaltung der ersten Teilschaltung mit Pull Down Widerständen.

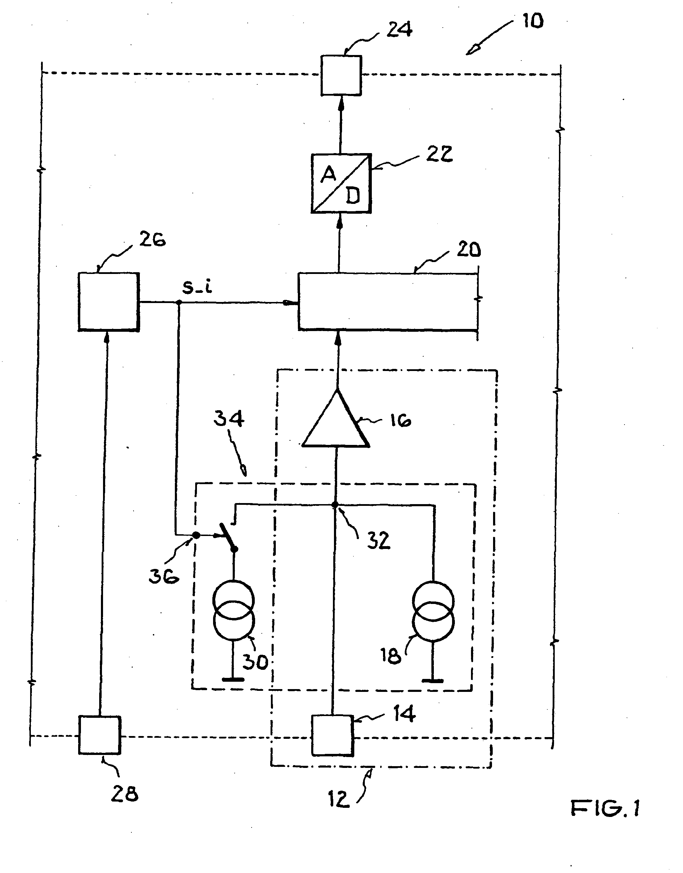

Im Einzelnen zeigt Figur 1 einen Ausschnitt aus einer integrierten Schaltung 10 mit einem digitalen Eingang 12. Es versteht sich, dass die Integrierte Schaltung 10 im Allgemeinen weitere digitale Eingänge aufweist. Der digitale Eingang 12 besitzt ein Eingangspad 14, über das Signale in die Integrierte Schaltung 10 eingespeist werden, einen Schwellenwertschalter 16 und eine Pull Down Stromquelle 18. Der Schwellenschalter 16 ist in der Regel als Schmitt-Trigger realisiert. Am Eingangspad 14 anliegende Eingangssignale, die den Schwellenwert des Schwellenwertschalters 16 überschreiten, werden an einen Digitalteil 20 der integrierten Schaltung 10 übergeben. Der Digitalteil 20 verarbeitet die Eingangssignale unter Berücksichtigung weiterer Signale zu einem oder mehreren digitalen Ausgangssignalen. Ein solches digitales Ausgangssignal kann über den Analog/Digitalwandler 22 in ein Analogsignal umgewandelt und an ein Ausgangspad 24 übergeben werden.

In der Ausgestaltung der Figur 1 wird das digitale Ausgangssignal insbesondere unter Berücksichtigung des Ausgangssignals des Schwellenwertschalters 16 und eines schaltungsinternen Signals S_i gebildet, das von einem Analogteil 26 ausgegeben wird. Der Analogteil stellt ein Beispiel einer zweiten Teilschaltung dar. Das schaltungsinterne Signal S_i ist ein Beispiel für ein Signal, das im Inneren der integrierten Schaltung 10 auftritt, jedoch nicht direkt an einem der Eingangspads oder Ausgangspads der integrierten Schaltung 10 abnehmbar ist. In der Ausgestaltung der Figur 1 wird das schaltungsinterne Signal S_i z. B. mit einer gewissen Zeitverzögerung dann gebildet, wenn an einem Analogeingang 28 der integrierten Schaltung 10 ein vorbestimmtes Signal auftritt. Die Integrierte Schaltung 10 weist ferner eine schaltbare Pull Down Stromquelle 30 auf.

Während die Pull Down Stromquelle 18 kontinuierlich einen ersten Strom von einem Knoten 32 des digitalen Eingangs 12 zieht, wird ein zweiter Strom, den die zweite Pull Down Stromquelle 30 ziehen kann, nur bei eingeschalteter Pull Down Stromquelle 30 von dem Knoten 32 abgezogen. Die beiden über den Knoten 32 zusammengeschalteten Pull Down Stromquellen 18 und 30 stellen zusammen eine erste Teilschaltung 34 mit veränderlicher Strom-Spannungs-Charakteristik dar, die ein Potenzial an dem Eingang 12, das heißt an dem Eingangspad 14 oder dem Knoten 32, bei fehlendem Eingangssignal auf einem definierten Wert hält.

Wenn man an das Eingangspad 14 ein Eingangssignal mit einer konstanten Spannung u anlegt, ändert sich der Signalstrom vom Eingangspad 14 zum Knoten 32 je nachdem, ob die schaltbare Stromquelle 30 eingeschaltet oder ausgeschaltet ist. Insofern besitzt die erste Teilschaltung 34 die genannte veränderliche Strom-Spannungs-Charakteristik. Die erste Teilschaltung 34 weist einen Steuereingang 36 für ein Steuersignal auf, mit dem die schaltbare Pull Down Stromquelle 30 eingeschaltet werden kann. In der Ausgestaltung der Figur 1 dient das bereits genannte schaltungsinterne Signal S_i als Steuersignal für die erste Teilschaltung 34.

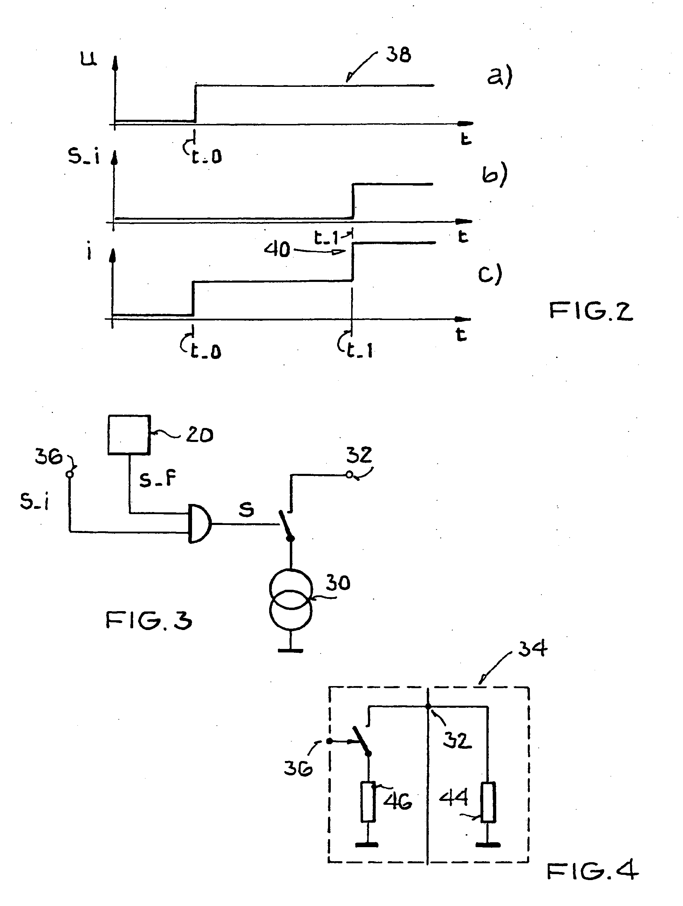

Figur 2a zeigt den zeitlichen Verlauf eines Spannungssignals 38 am Eingangspad 14, wie es durch Anschluss einer Konstantspannungsquelle an das Eingangspad 14 erzeugt werden kann. Zum Zeitpunkt t_0 wird die Konstantspannungsquelle eingeschaltet. Dann fließt ein Strom i von der Konstantspannungsquelle in den digitalen Eingang 12 zum Knoten 32. Der Strom i ersetzt genau die Abflüsse in den Schwellenwertschaltern 16 und in die Pull Down Stromquelle 18. Die schaltbare Pull Down Stromquelle 30 ist dabei zunächst ausgeschaltet, weil am Steuereingang 36 der ersten Teilschaltung 34 noch kein Steuersignal anliegt. Der Strom i stellt sich dann zum Beispiel auf einen konstanten Wert ein, wie er qualitativ in der Figur 2c zwischen den Zeiten t_0 und t_1 dargestellt ist.

Zum Zeitpunkt t_1 tritt dann innerhalb der integrierten Schaltung 10 das schaltungsinterne Signal S_i auf. In der Ausgestaltung der Figur 1 wird das Signal S_i von dem Analogteil 26 ausgegeben. Bei dem Signal S_i kann es sich aber auch um ein Signal handeln, das innerhalb des Digitalteils 20 der integrierten Schaltung 10 gebildet wird. Als internes Signal tritt dieses Signal S_i nicht an Eingängen oder Ausgängen der integrierten Schaltung 10 auf, so dass es nicht direkt detektiert werden kann. Um trotzdem eine Detektion zu ermöglichen, wird das interne Signal S_1 bei der Ausgestaltung der Figur 1 über den Steuereingang 36 der ersten Teilschaltung 34 zum Einschalten der schaltbaren Pull Down Stromquelle 30 genutzt.
Folglich wird die schaltbare Pull Down Stromquelle 30 beim Auftreten des schaltungsinternen Signals S_i zum Zeitpunkt t_1 eingeschaltet. Das Auftreten des schaltungsinternen Signals S_1 zum Zeitpunkt t_1 ist in der Fig. 2c dargestellt.

Durch das Einschalten der schaltbaren Pull Down Stromquelle 30 ändert sich die Spannungscharakteristik der ersten Teilschaltung 34. Die schaltbare Pull Down Stromquelle 30 zieht einen zusätzlichen Strom von dem Knoten 32 des digitalen Eingangs 12 ab. Die an dem Eingangspad 14 angeschlossene Konstantspannungsquelle muss diesen zusätzlich vom Knoten 32 abfließenden Strom ersetzen, um die Spannung am Eingangspad 14 konstant zu halten. Die Konstantspannungsquelle muss daher ab dem Zeitpunkt t_1 einen höheren Strom liefern als im Zeitraum zwischen t_0 und t_1. Dieser höhere Stromfluss über den Eingangspad 14 ist messbar und in der Figur 2c qualitativ durch den stufenförmigen Anstieg 40 zum Zeitpunkt t_1 dargestellt. Das Auftreten der Stufe im Stromsignal i zeigt daher das Auftreten des schaltungsinternen Signals S_i im Inneren der integrierten Schaltung an.

Die erste Teilschaltung 34 kann daher auch als Testhilfe-Schaltung betrachtet werden. Die Variation des Eingangsstroms durch Zuschalten der schaltbaren Pull Down Stromquelle 30 ist normalerweise unproblematisch, solange die Spezifikationswerte der Schaltung eingehalten werden. Die Variation des Eingangsstroms kann in einer Ausgestaltung der Figur 1, wie sie ausschnittsweise in der Figur 3 dargestellt ist, noch durch ein Freigabesignal S_f beeinflusst werden. In der Ausgestaltung der Figur 3 wird ein Steuersignal S, das die schaltbare Pull Down Stromquelle 30 zuschaltet, nur dann ausgegeben, wenn gleichzeitig das Signal S_i des Analogteils 26, das am Steuereingang 36 anliegt, und das Freigabesignal S_f, das bspw. von dem Digitalteil 20 ausgegeben wird, gleichzeitig vorliegen. In der Figur 3 wird dies durch die UND-Verknüpfung 42 repräsentiert.

Es versteht sich, dass die erste Teilschaltung 34 anstelle von Pull Down Stromquellen 18 und 30 auch Pull Up Stromquellen aufweisen kann. Eine weitere Alternative ist in der Figur 4 dargestellt. Figur 4 zeigt eine alternative erste Teilschaltung 34 mit einem einen Pull Down Widerstand 44, der die Stromquelle 18 aus der Figur 1 ersetzt. In diesem Fall wird die schaltbare Pull Down Stromquelle 30 aus der Figur 1 durch einen schaltbaren Pull Down Widerstand 46 ersetzt, wie er ebenfalls in der Fig. 4 dargestellt ist. Die Pull Down Widerstände 44, 46 können auch durch Pull Up Widerstände ersetzt werden.

## Patentansprüche

1. Integrierte Schaltung (10) mit wenigstens einem digitalen Eingang (12), der eine erste Teilschaltung (34) und eine zweite Teilschaltung (26) aufweist, die erste Teilschaltung (34) weist eine erste Stromquelle (18) auf, die ein Potenzial an dem Eingang (12) bei fehlendem Eingangssignal auf einem definierten Wert hält, die zweite Teilschaltung (26) ist für die Bereitstellung eines, schaltungsinternen Signals (S_i) ausgebildet, dessen Zustand sich nicht unmittelbar an einem Ausgang (24) der Schaltung (10) zeigt, wobei die erste Teilschaltung (34) einen Steuereingang (36) für ein Steuersignal und eine zweite, in Abhängigkeit eines am Steuereingang (36) anlegbaren Steuersignals schaltbare Stromquelle (30) aufweist, die eine Strom-Spannungs-Charakteristik am digitalen Eingang (12) ändert, wenn das Steuersignal am Steuereingang (36) anliegt, **dadurch gekennzeichnet, dass** die erste Stromquelle (18) und die zweite Stromquelle (30) beide als Pull-Down-Stromquelle oder beide als Pull-Up-Stromquelle oder beide als pull-Down-Widerstand oder beide als Pull-Up-Widerstand ausgebildet sind.

2. Schaltung (10) nach Anspruch 1, **dadurch gekennzeichnet, dass** das schaltungsinterne Signal (S_i) das Steuersignal ist.

3. Schaltung (10) nach Anspruch 1, **dadurch gekennzeichnet, dass** das Steuersignal das Ergebnis einer UND-Verknüpfung eines Freigabesignals mit dem schaltungsinternen Signal ist.

## Claims

1. Integrated circuit (10) with at least one digital input (12), which comprises a first part circuit (34) and a second part circuit (26), which first part circuit (34) has a first current source (18) keeping a potential at the input (12) to a defined value in the case of absent input signal and which second part circuit (26) is constructed for provision of a circuit-internal signal (S_i), the state of which does not directly appear at an output (24) of the circuit (10), wherein the first part circuit (34) has a control input (36) for a control signal and a second current source (30), which is switchable in dependence on a control signal able to be applied to the control input (36) and which changes a current/voltage characteristic at the digital input (12) when the control signal is present at the control input (36), **characterised in that** the first current source (18) and the second current source (30) are both constructed as a pull-down current source, as a pull-up current source, as a pull-down resistance or as a pull-up resistance.

2. Circuit (10) according to claim 1, **characterised in that** the circuit-internal signal (S_i) is the control signal.

3. Circuit (10) according to claim 1, **characterised in that** the control signal is the result of an AND linking of a release signal with the circuit-internal signal.

## Revendications

1. Circuit intégré (10) comprenant au moins une entrée numérique (12) présentant un premier circuit partiel (34) et un deuxième circuit partiel (26), le premier circuit partiel (34) présente une source de courant (18) qui maintient un potentiel à l'entrée (12) à une valeur définie en cas d'absence de signal d'entrée, le deuxième circuit partiel (26) est conçu pour mettre à disposition un signal (S_i) interne au circuit, dont l'état n'apparaît pas directement à la sortie (24) du circuit (10), le premier circuit partiel (34) présentant une entrée de commande (36) pour un signal de commande et une deuxième source de courant (30) pouvant être basculée en fonction d'un signal de commande applicable à l'entrée de commande (36), qui modifie une caractéristique de courant-tension à l'entrée numérique (12) lorsque le signal de commande est appliqué à l'entrée de commande (36), **caractérisé en ce que** la première source de courant (18) et la deuxième source de courant (30) sont conçues toutes deux sous la forme d'une source de courant d'excursion basse ou toutes deux sous la forme d'une source de courant d'excursion haute ou toutes deux sous la forme d'une résistance d'excursion basse ou toutes deux sous la forme d'une résistance d'excursion haute.

2. Circuit (10) selon la revendication 1, **caractérisé en ce que** le signal (S_i) interne au circuit est le signal de commande.

3. Circuit (10) selon la revendication 1, **caractérisé en ce que** le signal de commande est le résultat d'une liaison ET entre un signal de libération et un signal interne au circuit.
